# EUROPEAN PATENT APPLICATION

(11) **EP 1 329 934 A2**
(43) Date of publication of application: **23.07.2003**
(21) Application number: 03250265.0
(22) Date of filing: 16.01.2003
(51) Int. Cl.: H01J 17/28, H01J 7/28

(54) **Image display apparatus**

(30) Priority: 16.01.2002 KR 2002002432
(71) Applicant: SAMSUNG ELECTRONICS CO., LTD., Suwon-City, Kyungki-do (KR)
(72) Inventor: Kim, Won-nyun, Kwacheon-city, Gyunggi-do (KR)
(74) Representative: Geary, Stuart Lloyd

(57) **Abstract**

An image display apparatus (300) to equalize a temperature of a panel (310), such as a plasma display panel, LCD or the like. A radiating plate (320) has a heat transmission unit (330) for equalizing a surface temperature of the image display unit (310). The heat transmission unit (330) uses a loop heat pipe. The loop heat pipe (330) has a small amount of operation fluid inside, the inside of the loop heat pipe (330) being under vacuum. The loop heat pipe (330) circulates heat emitted from the image display unit (310) to equalize the temperature of the image display unit (310). Accordingly, the partial damage to the panel (310) caused by the high temperature heat generated from the panel (310) can be prevented, and the life span of the panel (310) can be extended. The equalized temperature of the panel (310) can reduce a brightness difference between the upper and lower ends of the panel (310).

## Description

The present invention relates to an image display apparatus, comprising a display panel and heat transfer means for conducting heat away from the display panel.

A plasma display panel (PDP) is a panel made of two base plates of glass, which are fixed to each other in an air-tight manner. The PDP displays an image by utilizing a gas discharge phenomenon and requires a relatively simple fabrication process. Using a PDP, it is also easy to make a large and thin display screen. The PDP generates a large amount of heat during the operation due to the gas discharge phenomenon. Most of the PDPs have a heat transfer apparatus that uses a fan and is disposed at a rear end of the panel, for releasing the heat outwardly.

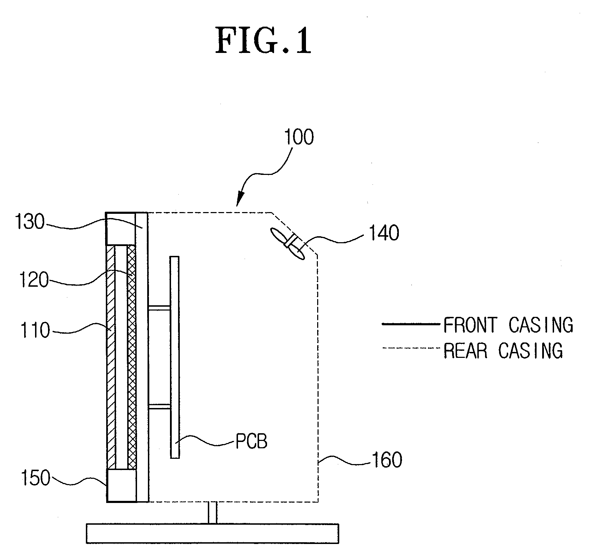

Figure 1 is a cross-sectional view showing an interior of a PDP having a conventional heat transfer apparatus. Referring to Figure 1, a PDP 100 having a conventional heat transfer apparatus comprises a filter 110, a panel 120, a heat sink (or radiating) plate 130, a fan 140, a front casing 150 and a rear casing 160. The filter 110 protects an image display apparatus such as the panel 120 from an external shock. The filter 110 is generally made from glass. The panel 120 consists of two base plates of glass formed typically with a gap of approximately 0.1mm therebetween. The gap between the two base plates is under vacuum, and there occurs a gas discharge phenomenon in the gap. Accordingly, the PDP 100 displays an image by utilizing the gas discharge phenomenon that occurs in the vacuous gap.

On a rear surface of the panel 120 is provided the heat sink plate 130 for transferring heat away from the panel 120. The heat sink plate 130 is made from metallic plate of a high thermal conductivity such as aluminum. At a rear surface of the heat sink plate 130 is provided at least one fan 140 for cooling the panel 120 during the operation of the PDP 100.

When the PDP 100 is driven, heat is generated inside the panel 120 due to the gas discharge phenomenon. Most of the generated heat is conducted to the heat sink plate 130 disposed at the rear surface of the panel 120. The fan 140 circulates the inner air of the PDP 100 to cool the heat sink plate 130. When the PDP 100 does not include the fan 140, the heat sink plate 130 is cooled by a natural convection caused by a temperature difference.

Figure 1 shows the front casing 150 in a thick solid line and the rear casing 160 in a dotted line. The front casing 150 is disposed at a front surface of the PDP 100 where the filter 110 is disposed and the rear casing 160 is typically disposed at a rear surface of the PDP 100 where the fan 140 is disposed, thereby protecting the PDP 100 from an external shock.

However, energy that is used for driving the PDP 100 is converted to heat and discharged outwardly. The heat generated by the PDP 100 heats the PDP 100 and the surrounding air, causing convection. A boundary layer is formed around the PDP 100 due to the convection. The boundary layer gradually thickens towards its upper end and the upper end of the boundary layer has a higher temperature during operation of the PDP 100 than a lower end of the boundary layer. Another main reason that the upper end has a higher temperature than the lower end is that an exhaust operation is not smoothly performed due to the presence of the rear casing 160.

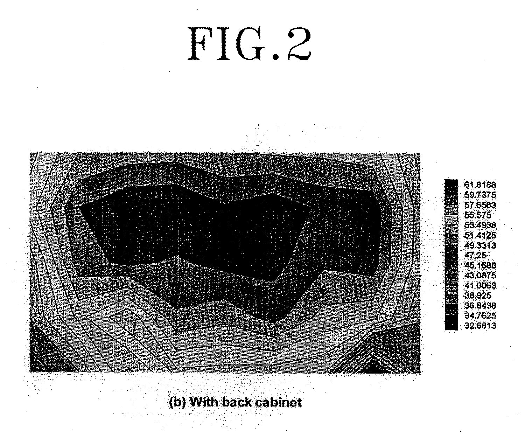

Figure 2 is an isothermal line showing a temperature distribution of the panel when the PDP is driven. Referring to Figure 2, the temperature distribution is irregular when the PDP 100 is driven and there is a great temperature difference between the upper end and the lower end. The temperature difference increases as the panel 120 is enlarged in size.

The temperature difference of the panel 120 shortens the life span of the PDP 100, and the upper end and the lower end have different capacities such that an even quality of image cannot be obtained. With a larger size PDP 100 especially, the temperature difference between the upper end and the lower end of the panel 120 increases. Also, there is a limit on the ability to equalize the temperature of the panel 120 with the heat sink plate 130 and the fan 140. Also, since the PDP 100 comprises the fan 140 for cooling the PDP 100, it is difficult to make the PDP 100 thinner. Additionally, power consumption is increased, and there is a problem of noise.

A display apparatus, according to the present invention, is characterised by temperature equalisation means for equalising the temperature of said display panel.

Preferably, the temperature equalisation means comprises a loop heat pipe. More preferably, the loop heat pipe contains a small amount of fluid and the inside of the loop heat pipe is under vacuum.

Preferably, the heat transfer means comprises a heat sink plate and the loop heat pipe is disposed along the margin of a major face of the heat sink plate.

Preferably, the loop heat pipe has a meandering portion between the evaporator section and the condenser section.

An embodiment of the present invention will now be described, by way of example, with reference to Figures 3 to 5, in which:
Figure 1 is a cross-sectional view showing an interior of a PDP comprising a conventional heat transfer apparatus;
Figure 2 is an isothermal line showing a temperature distribution of a panel when a PDP is driven;
Figure 3 is a view showing the basic structure of an image display apparatus according to a preferred embodiment of the present invention;
Figure 4 is a view showing a heat sink plate comprising a loop heat pipe according to a preferred embodiment of the present invention; and
Figure 5 is a view showing a general loop heat pipe according to the present invention to explain the operation of the loop heat pipe.

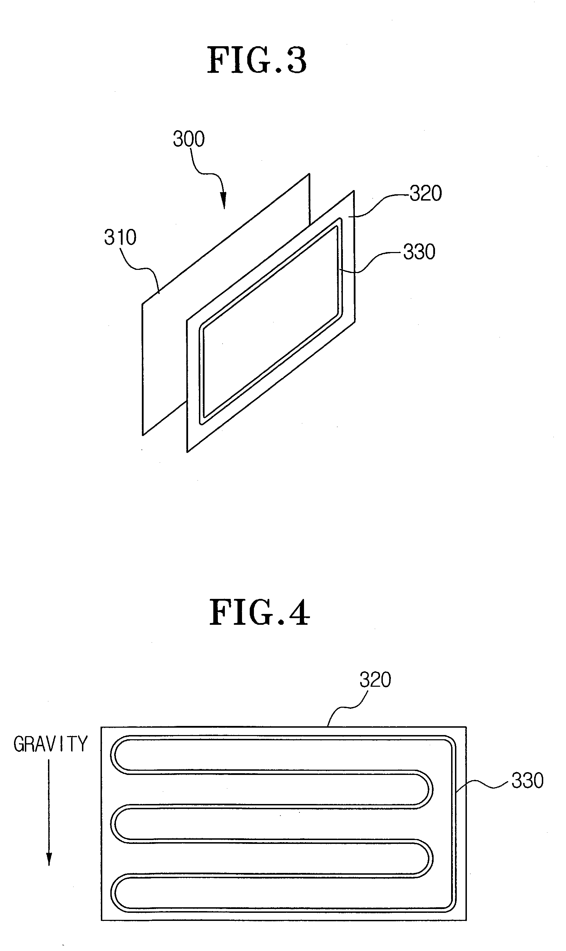

Referring to Figure 3, an image display apparatus 300 according to the present invention comprises an image display unit 310, a heat sink plate 320 and a heat transmission unit 330. The image display unit 310 uses a plasma display panel (PDP), a liquid crystal display (LCD) or another type of flat panel display now known or in the future discovered suitable for use with the present invention. The image display unit 310 of the present example uses a PDP.

The heat sink plate 320 is attached to a rear surface of the PDP 310. The heat sink plate 320 is typically made of metallic material such as aluminum that has a high thermal conductivity. On the heat sink plate 320 is provided the heat transmission unit 330. The heat transmission unit 330 uses a loop heat pipe 330. As shown in Figure 3, the loop heat pipe 330 forms a closed loop and is disposed in the margin of a major face of the heat sink plate 320.

It is preferred that the loop heat pipe 330 be formed symmetrically with respect to vertical and horizontal centre lines of the heat sink plate 320. The loop heat pipe 330 can be shaped as a circle, an ellipse, or a polygon such as a triangle and a square. Also, as shown in Figure 4, the loop heat pipe 330 can be formed all over the heat sink plate 320 in a meandering or zigzag fashion. The meandering fashion of the loop heat pipe 330 allows the PDP 310 to be protected from an external shock and helps the loop heat pipe 330 and the PDP 310 to have a regular temperature. The meandering pattern shown in Figure 4 is but one illustrative type of many meandering patterns that may be used. The meandering pattern of Figure 4 is not symmetrical with respect to both the horizontal and vertical centre lines of the heat sink plate 320.

The loop heat pipe 330 is a heat transfer apparatus that moves a large amount of heat by utilizing the latent heat of vaporisation of an operation fluid (sometimes called a working fluid) in the loop heat pipe 330, even with a small temperature difference and regardless of gravity. The operation fluid uses material such as distilled water or another suitable liquid that is phase-changeable according to the temperature. The inside of the loop heat pipe 330 is under vacuum.

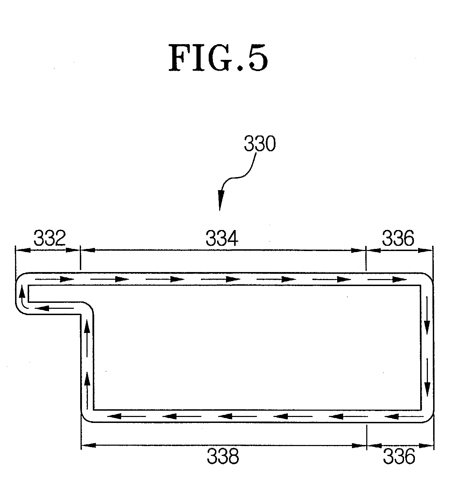

Referring to Figure 5, the loop heat pipe 330 comprises an evaporator section 332, a first adiabatic section 334, a condenser section 336 and a second adiabatic section 338.

When the image display apparatus 300 is driven, the PDP 310 generates heat. For the same reason as described above, the upper end of the PDP 310 has a higher temperature than the lower end. That is, the upper end of the PDP 310 becomes a heat source for the loop heat pipe 330. It is preferred that the operation fluid is placed at an opposite position to the heat source.

The heat source is in thermal contact with the evaporator 332, and a small amount of the operation fluid injected into the evaporator 332 boils due to the heat transferred from the upper end of the PDP 310, i.e., the heat source. Since the loop heat pipe 330 is under vacuum, the operation fluid is easy to boil even with a small temperature difference. The operation fluid evaporated by the heat source spreads inside the loop heat pipe 330.

The evaporated operation fluid passes along the first adiabatic section 334 and condenses at the condenser 336, giving up the latent heat of vaporisation of the operation fluid to the condenser 336. After the condensation, the liquefied operation fluid passes along the second adiabatic section 338 and returns to the evaporator 332, which is in thermal contact with the heat source. By the repeat of the evaporation and condensation of the operation fluid by the heat source, the heat is transferred. That is, the operation fluid continually circulates in the loop heat pipe 330 through the repeated evaporation and liquefaction by the heat source.

When the operation fluid reaches its boiling point, the liquid and vapor of the operation fluid maintain an equal temperature. The liquid and vapor is changed and moved at a high speed in the loop heat pipe 330. Accordingly, the loop heat pipe 330 maintains the equal inner temperature due to the speedy movement of the liquid and vapor of the operation fluid. By making use of the loop heat pipe 330, the surface temperature of the PDP 310 is equalized. Also, the operation fluid moves at high speed such that the PDP 310 maintains the equalized temperature without an extreme temperature change.

As the loop heat pipe 330 is not affected by gravity to the same extent as a conventional heat pipe, the evaporated operation fluid can be transferred by a greater distance. Since the loop heat pipe 330 is able to transfer heat in the opposite direction to the force of gravity, which differs from a conventional heat pipe, it is also able to transfer the heat from the upper end of the PDP 310 to the lower end. Accordingly, even with the PDP 310 being enlarged and the loop heat pipe 330 having a long length, the operation fluid maintains its heat transfer rate, and thus, the enlarged PDP 310 can have its temperature equalized.

According to the present invention, the image display apparatus that uses a panel such as the PDP, the LCD or the like is provided with the loop heat pipe, such that the extreme temperature difference between the upper and lower ends of the panel is reduced and the temperature of the panel is equalized. Of particular importance, the partial damage to the panel that may be caused by the high temperature heat generated from a certain part of the panel can be prevented, and accordingly, the life span of the panel can be extended. The equalized temperature of the panel can reduce a brightness difference between the upper and lower ends of the panel.

## Claims

1. An image display apparatus (300) comprising a display panel (310) and heat transfer means (320) for conducting heat away from the display panel (310), **characterised by** temperature equalisation means (330) for equalising the temperature of said display panel (310).

2. An apparatus according to claim 1, wherein the temperature equalisation means (330) comprises a loop heat pipe.

3. An apparatus according to claim 2, wherein the loop heat pipe (330) contains a small amount of fluid and the inside of the loop heat pipe is (330) under vacuum.

4. An apparatus according to claims 2 or 3, wherein the heat transfer means (320) comprises a heat sink plate and the loop heat pipe (330) is disposed along the margin of a major face of the heat sink plate.

5. An apparatus according to claims 2 or 3, wherein the loop heat pipe (330) has a meandering portion between an evaporator section (332) and a condenser section (336) thereof.

6. An image display apparatus (300) comprising:
an image display unit (310) for displaying an image on a screen; and
a radiating plate (320) having a heat transmission unit (330) for equalizing a surface temperature of the image display unit by circulating heat emitted from the image display unit (310).

7. The image display apparatus of claim 6, wherein the heat transmission unit (330) is a loop heat pipe.

8. The image display apparatus of claim 7, wherein the loop heat pipe (330) has inside a small amount of operation fluid, the inside of the loop heat pipe (330) being under vacuum.

9. The image display apparatus of claim 6, wherein the heat transmission unit (330) is shaped in a closed loop and is disposed around an edge of the radiating plate (320).

10. The image display apparatus of claim 6, wherein the heat transmission unit (330) is shaped in a closed loop and is formed in a zigzag fashion.
